# EUROPEAN PATENT SPECIFICATION

(11) **EP 2 214 305 B1**
(45) Date of publication and mention of the grant of the patent: **12.10.2011**
(21) Application number: 09001272.5
(22) Date of filing: 30.01.2009
(51) Int. Cl.: H03F 1/02

(54) **Digitally controlled SMALA**
Digital gesteuerter getakteter Linearverstärker
SMALA commandée numériquement

(43) Date of publication of application: 04.08.2010
(73) Proprietor: Alcatel Lucent, 75007 Paris (FR)
(72) Inventor: Bohn, Thomas, 79372 Stuttgart (DE); Wiegner, Dirk, 71409 Schwaikheim (DE); Machinal, Robin, 70173 Stuttgart (DE)
(74) Representative: Schmidt, Werner Karl

(56) References cited:
- WO-A-2006/127714
- US-A1- 2005 064 830
- US-A1- 2008 104 432
- US-A1- 2008 284 510
- US-B1- 6 175 273
- US-B1- 6 300 826

## Description

### Background of the invention

The invention relates to a method for operating a digital in - analogue out radio frequency amplifier, further referred to as DARFA, wherein a digital input signal is processed in a digital signal processing unit, further referred to as DSP unit, generating a processed digital baseband signal out of the digital input signal,
wherein an analogue RF input signal with a non-constant envelope is generated out of the processed digital baseband signal,
wherein the analogue RF input signal is fed into an RF power amplifier which generates an amplified analogue RF output signal out of the analogue RF input signal,
wherein the RF power amplifier receives a supply voltage from a modulator unit,
wherein the modulator unit comprises a linear amplifier stage and a switching amplifier stage, whose outputs are combined to one common modulator output providing the supply voltage and supply current,
and wherein the input of the linear amplifier stage is fed with an analogue input signal corresponding to the envelope of the processed digital baseband signal. Examples of this type of amplifier can be found in patent documents WO 2006/127714 and US2005/0064830.

In mobile telecommunication systems, it is required to generate from a digital input signal an amplified analogue radio frequency (RF) output signal, e.g. for operating a transmitter antenna. This is done by a digital in-anatogue out radio frequency amplifier (DARFA). At the output of the DARFA, there is typically a linear RF power amplifier which generates the amplified analogue RF output signal from an analogue RF input signal. The RF power amplifier receives a supply voltage; this supply voltage limits the maximum amplitude of the amplified analogue RF output signal.

In mobile telecommunication applications, the analogue RF input signal typically is a result of a complex modulation scheme, resulting in strongly varying signal envelopes with a high peak to average ratio (PAR). The digital information is contained in a baseband signal (typically of MHz frequency range), which is modulated on a carrier signal (typically in GHz range).

In a simple approach, the supply voltage of the RF power amplifier can be chosen so high that all analogue RF input signal levels can be amplified without distortions. However, this results in clearly reduced amplifier efficiency and thus in high thermal power loss in the RF power amplifier.

In a more advanced approach, the supply voltage of the RF power amplifier is adapted to the analogue RF input signal present at the signal input of the RF power amplifier. The supply voltage follows the envelope of the analogue RF input signal, so that a sufficiently high supply voltage is present to avoid distortions when the signal level of the analogue RF input signal is high, but also so that the supply voltage is kept low to reduce thermal power loss during times when the signal level of the analogue RF input signal is low. This approach is called envelope tracking.

In order to realize envelope tracking, the RF power amplifier is operated by a modulator unit (also called envelope modulator). A known topology for the modulator unit is the switch mode assisted linear amplifier (SMALA) concept The modulator unit comprises a linear amplifier stage and a switching amplifier stage, which are both connected to the modulator output where the supply voltage is provided. The linear amplifier stage amplifies an analogue input signal corresponding to the envelope of the analogue RF input signal to be amplified in the RF power amplifier. When the analogue input signal level is high enough, the linear amplifier stage is supported by the switching amplifier stage which provides a fixed contribution (power provision) to the supply current The non-linear switching amplifier stage helps to increase the efficiency of the modulator unit, while the linear amplifier stage keeps the modulator unit's characteristic linear.

In the known SMALA concept, the linear amplifier stage is followed by a measuring resistor, and the voltage across the resistor is analyzed by means of a comparator, which triggers the switching amplifier stage. However, the characteristics of the resistor and the comparator show imperfections such as thermal variations or a comparator hysteresis, This clearly limits bandwidth and flexibility of the SMALA concept. In particular, the biasing of the RF power amplifier becomes inaccurate, which may lead e.g. to an increased thermal power loss and even signal distortions.

### Object of the invention

It is the object of the invention to provide a method for operating a DARFA as introduced in the beginning, which allows a higher accuracy in the control of the RF power amplifier.

### Summary of the invention

This object is achieved, in accordance with the invention, by a method as introduced in the beginning, characterized in that the switching amplifier stage is controlled by means of a pulse width modulated signal generated within the DSP unit, wherein the pulse width modulated signal is derived digitally from the partially or completely processed digital baseband signal.

According to the invention, the pulse width modulated signal which controls the switching amplifier stage is not generated within the modulator unit by means of a resistor and a comparator, but provided by the digital part of the DARFA, i.e. the DSP unit. In other words, the invention does without a control stage internal of the modulation unit.

Since the DSP unit generates the processed digital baseband signal, which is the basis of the analogue RF input signal of the RF power amplifier and for the analogue input signal of the linear amplifier stage, also the envelope of the analogue RF input signal which will be present at the input of the RF power amplifier is known (i.e. it can be predicted precisely) in the DSP unit.

Using this knowledge, the DSP unit can also generate a highly precise control signal for the switching amplifier stage, which has the form of a pulse width modulated signal. During times in which the envelope of the analogue RF input signal will be at or above a specified level, the pulse width modulated signal is provided with a high signal level (which keeps the switching amplifier stage turned on), and during times in which the envelope of the analogue RF input signal will be below said specified level, the pulse width modulated signal is provided with a low signal level (which keeps the switching amplifier stage turned off). By this means, the switching amplifier stage can be activated precisely when it is necessary (and possible) to support the linear amplifier stage.

It should be noted that the pulse width modulated signal need not be derived from the final processed digital baseband signal, but can also be derived in a partially processed state of the digital input signal of the DARFA provided that the envelope of the analogue RF input signal can already be concluded. It should also be noted that the pulse width modulated signal may undergo some signal processing between the DSP unit and the switching amplifier stage; however its control information content will not be changed therewith, in accordance with the invention.

By keeping the generation of the pulse width modulated signal for controlling the switching amplifier stage in the digital part of the DARFA, the control of the modulator unit, and in particular the control of the switching amplifier stage, can be done with high accuracy, minimizing thermal power losses and distortions, and allowing a wide bandwidth of operation. Additionally, a simple later tuning possibility can be achieved.

### Preferred embodiments of the invention

In a preferred variant of the inventive method, the analogue input signal for the linear amplifier stage is generated within the DSP unit, wherein said analogue input signal is derived digitally from the partially processed or completely processed baseband signal. By this means, the procedure of controlling the modulator unit can be further increased. In particular, it is not necessary to extract the envelope of the already generated analogue RF input signal. It should be noted that the analogue input signal may undergo some signal processing between the DSP unit and the linear amplifier stage; however its control information content will not be changed therewith, in accordance with the invention.

Further preferred is a variant wherein for generating the analogue RF input signal, the DARFA comprises an analogue mixer, mixing an RF carrier signal with the processed digital baseband signal. This offers a simple way of mixing, wherein the DSP unit is exculpated from high speed operations. It is particularly suited for RF carrier signals with a high frequency of 1,8 GHz and above. Note that the processed digital baseband signal is typically D/A-converted in a D/A converter stage connected just before the analogue mixer.

In an alternative variant, for generating the analogue RF input signal, the DSP unit comprises a digital mixing stage which mixes the partially or completely processed baseband signal with an RF carrier signal. In this variant, the mixing step is performed already within the DSP unit, making a separate analogue mixing stage superfluous. This variant is particularly useful in case the desired carrier frequency of the analogue input (or amplified) RF signal is relatively low.

In a third, preferred variant, for generating the analogue RF input signal, the DSP unit comprises a digital mixing stage which mixes the partially or completely processed digital baseband signal with an IF signal, and the DARFA comprises an analogue mixer, mixing an RF carrier signal with the IF-mixed processed digital baseband signal. In this variant, a part of the mixing is done digitally (up to the intermediate frequency (IF) level where digital processing is still fast enough) and some of the mixing is done in the analogue way (which is capable of high frequencies above the IF level). Thus high quality high frequency analogue RF output signals can be generated.

Further preferred is a variant, characterized in that the processed digital baseband signal has a bandwidth of between 1 MHz and 100 MHz, in particular about 30 MHz, and that the analogue RF input signal (or amplified analogue RF output signal) has a carrier frequency of between 400 and 6000 MHz, in particular about 1800 MHz or 2100 MHz or 2600 MHz. These frequency ranges are of particular importance for telecommunication systems, wherein energy conservation is particularly favoured due to a high spread of such systems, and wherein the invention can be applied.

In a particularly preferred variant, the modulator unit's analogue input signal is derived digitally from the partially processed or completely processed digital baseband signal including a digital time alignment within the DSP unit, subsequently converted into an analogue baseband signal and fed to the linear amplifier stage's input via an interface network. Apart from the control accuracy due to the digital signal generation per se, the digital time alignment allows an adaptation to the specific characteristics of the DARFA, in particular with respect to the RF power amplifier and the modulator unit and their components, respectively. Apart from the digital time alignment, also a signal conditioning may be done in the DSP unit upon digitally deriving the analogue input signal.

Further preferred is a variant wherein the supply voltage or the supply current at the modulator output is read out and used as a feedback measurement for the generation of the pulse width modulated signal in the DSP unit used for controlling the modulator unit's switching amplifier stage. The feedback can further increase the stability, accuracy and efficiency of the DARFA. The feedback measurement can also be used for generation of the linear amplifier stage's analogue input signal.

In another preferred variant of the inventive method, the pulse width modulated signal generated within the DSP unit is adapted to compensate for hysteresis and/or delay in parts of the DARFA. Typically, this includes a digital time (or delay) alignment within the DSP unit. This adaptation allows a significant increase in accuracy and efficiency of the controlling of the modulator unit. Also within the scope of the present invention is a digital in - analogue out radio frequency amplifier, further referred to as DARFA, wherein a supply voltage modulator unit of the DARFA is of the switch mode assisted linear amplifier principle type, further referred to as SMALA, comprising
- a DSP unit for processing a digital input signal into a processed digital baseband signal,
- means for generating an analogue RF input signal with a non-constant envelope out of the processed digital baseband signal,
- an RF power amplifier, the input of which is connected to said means for generating the analogue RF input signal,
- the modulator unit, with a modulator output which is connected to a supply voltage input of the RF power amplifier,
   wherein the modulator unit comprises a linear amplifier stage and a switching amplifier stage, whose outputs are both connected to the modulator output, characterized in that a control input of the switching amplifier stage is connected to a control output of the DSP unit providing a pulse width modulated signal derived digitally from the partially or completely processed digital baseband signal. The inventive DARFA can provide a high efficiency and a high linearity for the amplified analogue RF output signal due to a highly precise digital control of the modulator unit and the supply voltage of the RF power amplifier, respectively.

In a preferred embodiment of the inventive DARFA, the linear amplifier stage comprises at least one operational amplifier. In simple cases, a single operational amplifier, in particular in a voltage follower circuitry, is sufficient for operating the linear amplifier stage. In most cases, however, voltage gain and high output current are desired, so that the linear amplifier stage comprises a line-up of several amplifiers.

In a preferred embodiment, the switching amplifier stage comprises a diode and a MOSFET connected in series, wherein the gate of the MOSFET is connected to a MOSFET gate driver. The gate driver receives the pulse width modulated signal. This is a simple concept for a switching amplifier stage proven in practice.

Another embodiment provides that the modulator unit's linear amplifier stage is connected to the DSP unit via an interface alignment stage, which converts the partially or completely processed digital baseband signal into the analogue input signal on baseband level. Note that the interface alignment stage may have further functions with respect to signal conversion. This embodiment improves the cooperation of the DSP unit and the linear amplifier stage of the modulator unit.

Further preferred is an embodiment wherein the DARFA comprises a feedback loop comprising an analogue-to-digital converter, reading out the modulator output or the output of the RF power amplifer, and feedbacking to the DSP unit The feedback can further increase the stability, accuracy and efficiency of the DARFA.

Finally, also within the scope of the present invention is the use of an inventive DARFA in a mobile telecommunication system or a user terminal or a satellite system.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawing

The invention is shown in the drawing.
- Fig. 1: shows schematically the output side of a DARFA with a SMALA modulator unit of prior art;
- Fig. 2: shows schematically the output side of an inventive DARFA with a digitally controlled modulator unit;
- Fig. 3: shows schematically an inventive DARFA.

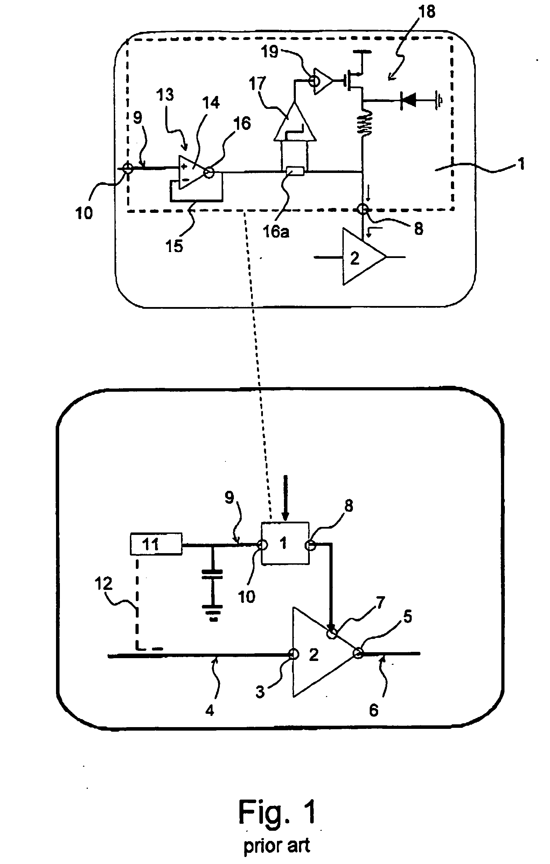

Fig. 1 shows the output side of a DARFA with a modulator unit 1 according to the prior art. The DARFA comprises an RF power amplifier 2 with an input 3 for an analogue RF input signal 4, and an output 5 for an amplified analogue RF signal 6. The RF power amplifier 2 has a supply voltage input 7, which is connected to a modulator output 8 of a modulator unit 1.

At the input 10 of the modulator unit 1, an analogue input signal 9 is present. Said signal 9 is provided by a detector 11, which reads out the analogue RF input signal 4 via sensor line 12. The analogue input signal 9 provided by the detector 11 corresponds to the envelope of the analogue RF input signal 4.

The modulator unit 1 (shown in more detail in the top part of Fig. 1) comprises a linear amplifier stage 13, here comprising an operational amplifier 14 with a voltage follower circuitry 15. The analogue input signal 9 is fed into the operational amplifier 14.

The output 16 of the operational amplifier 14 is connected to the modulator output 8 via a measuring resistor 16a. The voltage across the measuring resistor 16a is analyzed by a comparator 17. When the operational amplifier 14 has to provide a certain (minimum) current level, corresponding to a critical (minimum) voltage across the measuring resistor 16a, the comparator 17 triggers a switching amplifier stage 18 by providing a signal at the control input 19 of the switching amplifier stage 18. The switching amplifier stage 18 then provides an additional power (current) to the modulator output 8, thus disencumbering the linear amplifier stage 13.

However, the measuring resistor 16a exhibits thermal noise, and the comparator 17 is a relatively slow and hysteretic part which may cause the switching amplifier stage 18 to provide its power too late after a signal increase of the analogue input signal 9, or even no power is provided by the switching amplifier stage 18, which could finally lead to the defect of the linear amplifier stage 13.

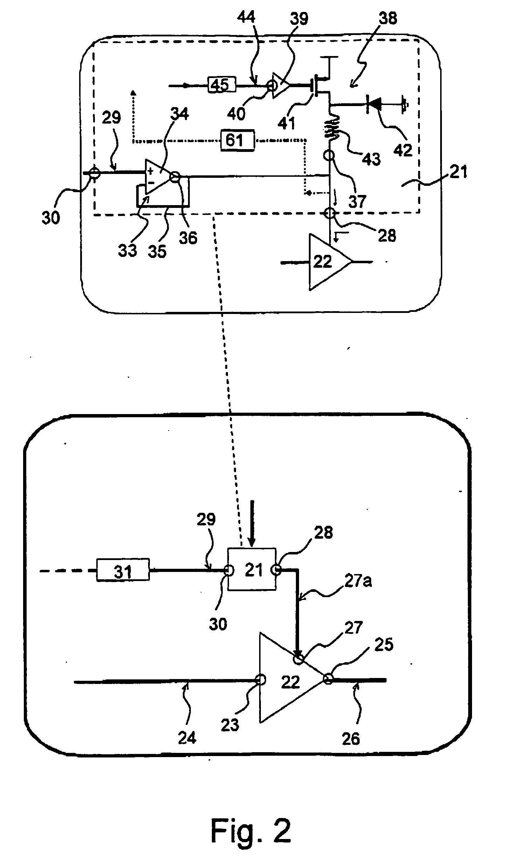

Fig. 2 shows the output side of a DARFA with a modulator unit (envelope modulator) 21 in accordance with the invention.

The DARFA comprises an RF power amplifier 22 with an input 23 for an analogue RF input signal 24, and an output 25 for an amplified analogue RF signal 26. The RF power amplifier 22 has a supply voltage input 27, which is connected to a modulator output 28 of a modulator unit 21.

At the input 30 of the modulator unit 21, an analogue input signal 29 is present Said signal 29 is provided here by an interface alignment unit 31, which is connected to a DSP unit (not shown). The DSP unit in cooperation with the interface alignment unit 31 provides that the analogue input signal 29 corresponds to the envelope of the analogue RF input signal 24 (and thus also corresponds to the envelope of a processed digital baseband signal of the DSP unit, from which the analogue RF input signal 24 is generated).

The modulator unit 21 (shown in detail in the top part of Fig. 2) comprises a linear amplifier stage 33, here comprising an operational amplifier 34 with a voltage follower circuitry 35. The analogue input signal 29 is fed into the operational amplifier 34. Its output 36 is directly connected with the modulator output 28.

Also connected with the modulator output 28, thus making the modulator output 28 a common output, is an output 37 of a switching amplifier stage 38. The switching amplifier stage 38 comprises a gate driver 39, whose signal input is the control input 40 of the switching amplifier stage 38, and a MOSFET 41 connected in series with a diode 42. The output 37 is connected between the MOSFET 41 and the diode 42 via an inductor 43.

The switching amplifier stage 38 receives a pulse width modulated signal 44 from an interface alignment unit 45, which is connected to a DSP unit (not shown). The DSP unit derives digitally the pulse width modulated signal from a partially or completely processed digital baseband signal, which is also the basis for the analogue RF input signal 24 of the RF power amplifier 22. The DSP unit is adapted to switch the pulse width modulated signal 44 such that it is high level when the partially or completely processed digital baseband signal indicates that the envelope of the analogue RF input signal 24 is above a specified level so that the switching amplifier stage 38 is needed (or desired) for contributing to the supply current at the input 27 for the RF power amplifier 22. If the envelope of the analogue RF input signal 24 is below the specified level, the DSP unit sets the pulse width modulated signal 44 to low level.

Since the pulse width modulated signal 44 is derived digitally in the DSP unit, the control of the switching amplifier stage 38 can be done very exactly. To even further increase the control accuracy, in the example shown, the supply voltage 27a at the modulator output 28 is read out, fed into an analogue-to-digital conversion unit 61 and fed into the DSP unit (not shown), in order to establish a closed loop control and maybe signal conditioning of the pulse width modulated signal 44 and/or the analogue input signal 29.

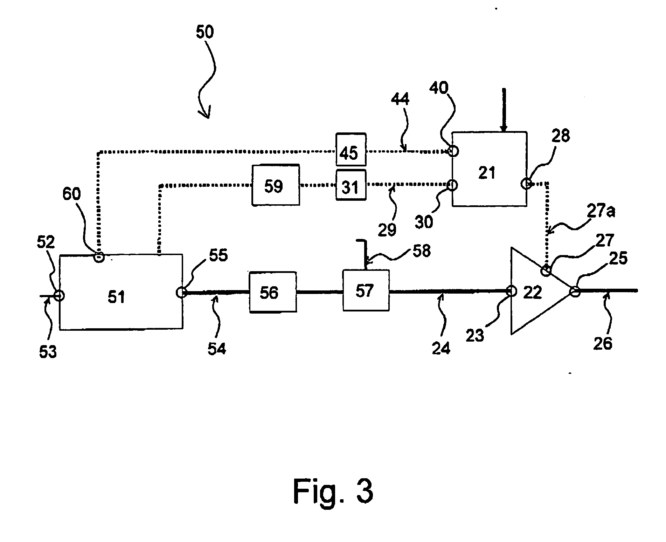

Fig. 3 shows a schematic overview of an inventive DARFA 50. In the example shown, the DARFA 50 comprises a DSP unit 51 with an input 52 receiving a (serial) digital input signal 53. In the DSP unit 51, the digital input signal 53 is digitally processed into a processed digital baseband signal 54, which is fed via an output 55 to a digital-to analogue-converter 56. After D/A conversion, the signal is fed into an analogue mixer 57 where it is mixed with an RF carrier signal 58, here originating from a local oscillator. The resulting analogue RF input signal 24 is fed into the (signal) input 23 of an RF power amplifier 22.

Note that in the example shown, the mixing is analogue only. However, it is also possible to perform the mixing step completely in the DSP unit 51, or partially within the DSP unit 51 up to an intermediate frequency and partially outside the DSP unit 51 by an analogue mixer.

The RF power amplifier 22 receives its supply voltage 27a from a modulator unit 21 including a linear amplifier stage and a switching amplifier stage (see Fig. 2, top part). The modulator unit 21, or more precisely its switching amplifier stage, is operated with a pulse width modulated signal 44, which is digitally derived within the DSP unit 51 from the partially or completely processed digital baseband signal 54 (known in the DSP unit 51), and which is adapted to the needs of the modulator unit 21 by means of an interface alignment unit 45 after having been tapped at a control output 60 (note that said interface alignment unit 45 can also be integrated into the modulator unit 21, as shown in Fig. 2, or into the DSP unit 51). Further, the modulator unit 21, or more precisely its linear amplifier stage, is operated with an analogue input signal 29 corresponding to the envelope of the processed digital baseband signal 54, which is also digitally derived within the DSP unit 51 from the partially or completely processed digital baseband signal 54, and which is prepared to cooperate with the modulator unit 21 by means of a digital-to-analogue conversion unit 59 and an interface alignment stage 31.

In accordance with the invention, both control signals (i.e. the pulse width modulated signal 44 and the analogue input signal 29) are originally digitally derived from the completely or partially processed digital baseband signal 54 within the DSP unit 51. Thus in particular the control of the switching amplifier stage within the modulator unit 21 is in the digital TX part on baseband level.

It is noted that the DSP unit 51 may include, for processing of the digital input signal 53, a clipping stage, a predistortion stage, and/or an image & carrier suppression stage. The pulse width modulated signal 44 and the analogue input signal 29 can be derived, in particular, from a partially processed signal just having undergone clipping. Both the pulse width modulated signal 44 and the analogue input signal 29 are preferably put through a delay stage in the DSP unit 51 each, to achieve an optimum control of the RF power amplifier 22 by means of the modulator unit 21, in particular with respect to efficiency and linearity. Both signals 29, 44 can be additionally put through a signal conditioning stage of the DSP unit 51, e.g. taking into account the modulator unit's transfer characteristics.

The pulse width modulated signal 44 and the analogue input signal 29 are coordinated by the digital means of the DSP unit 51 such that
- the switching amplifier stage is turned on as long as the power demand of the RF power amplifier 22 (which is a function of the envelope of the analogue RF input signal 24) is equal to or greater than a specified power level,
- and that the envelope of the analogue input signal 29 of the linear amplifier stage is in phase with the envelope of the analogue RF input signal 24, taking into account the reaction times (delays) of the involved parts of the DARFA 50. The invention is in particular useful with the W-CDMA digital modulation scheme, and for applications in GSM, UMTS and WiMAX telecommunication systems, as well as satellite systems.

## Claims

1. Method for operating a digital in - analogue out radio frequency amplifier, further referred to as DARFA (50),
wherein a digital input signal (53) is processed in a digital signal processing unit, further referred to as DSP unit (51), generating a processed digital baseband signal (54) out of the digital input signal (53), wherein an analogue RF input signal (24) with a non-constant envelope is generated out of the processed digital baseband signal (54),
wherein the analogue RF input signal (24) is fed into an RF power amplifier (22) which generates an amplified analogue RF output signal (26) out of the analogue RF input signal (24),
wherein the RF power amplifier (22) receives a supply voltage (27a) from a modulator unit (21),
wherein the modulator unit (21) comprises a linear amplifier stage (33) and a switching amplifier stage (38), whose outputs (36, 37) are combine to one common modulator output (28) providing the supply voltage (27a) and supply current,
and wherein the input (30) of the linear amplifier stage (33) is fed with an analogue input signal (29) corresponding to the envelope of the processed digital baseband signal (54),
**characterized in that**
the switching ample stage (38) is controlled by means of a pulse width modulated signal (44) generated within the DSP unit (51), wherein the pulse width modulated signal (44) is derived digitally from the partially or completely processed digital baseband signal (54).

2. Method according to claim 1, **characterized in that** the analogue input signal (29) for the linear amplifier stage (33) is generated within the DSP unit (51), wherein said analogue input signal (29) is derived digitally from the partially processed or completely processed baseband signal (54).

3. Method according to claim 1, **characterized in that** for generating the analogue RF input signal (24), the DARFA (50) comprises an analogue mixer (57), mixing an RF carrier signal (58) with the processed digital baseband signal (54).

4. Method according to claim 1, **characterized in that** for generating the analogue RF input signal (24), the DSP unit (51) comprises a digital mixing stage which mixes the partially or completely processed baseband signal (54) with an RF carrier signal.

5. Method according to claim 1, **characterized in that** for generating the analogue RF input signal (24), the DSP unit (51) comprises a digital mixing stage which mixes the partially or completely processed digital baseband signal (54) with an IF signal, and the DARFA (50) comprises an analogue mixer, mixing an RF carrier signal with the IF-mixed processed digital baseband signal,

6. Method according to claim 1, **characterized in that** the processed digital baseband signal (54) has a bandwidth of between 1 MHz and 100 MHz, in particular about 30 MHz, and that the analogue RF input signal (24) has a carrier frequency of between 400 and 6000 MHz, in particular about 1800 MHz or 2100 MHz or 2600 MHz.

7. Method according to claim 1, **characterized in that** the modulator unit's (21) analogue input signal (29) is derived digitally from the partially processed or completely processed digital baseband signal (54) including a digital time alignment within the DSP unit (51), subsequently converted into an analogue baseband signal and fed to the linear amplifier stage's (33) input (30) via an interface network.

8. Method according to claim 1, **characterized in that** the supply voltage (27a) or the supply current at the modulator output (28) is read out and used as a feedback measurement for the generation of the pulse width modulated signal (44) in the DSP unit (51) used for controlling the modulator unit's (21) switching amplifier stage (38).

9. Method according to claim 1, **characterized in that** the pulse width modulated signal (44) generated within the DSP unit (51) is adapted to compensate for hysteresis and/or delay in parts of the DARFA (50).

10. Digital in - analogue out radio frequency amplifier, further referred to as DARFA (50), wherein a supply voltage modulator unit (21) of the DARFA (50) is of the switch mode assisted linear amplifier principle type, further referred to as SMALA, comprising
- a DSP unit (51) for processing a digital input signal (53) into a processed digital baseband signal (54),
- means for generating an analogue RF input signal (24) with a non-constant envelope out of the processed digital baseband signal (54),
- an RF power amplifier (22), the input (23) of which is connected to said means for generating the analogue RF input signal (24),
- the modulator unit (21), with a modulator output (28) which is connected to a supply voltage input (27) of the RF power amplifier (22),
wherein the modulator unit (21) comprises a linear amplifier stage (33) and a switching amplifier stage (38), whose outputs (36, 37) are both connected to the modulator output (28),
**characterized in that**
a control input (40) of the switching amplifier stage (38) is connected to a control output (60) of the DSP unit (51) providing a pulse width modulated signal (44) derived digitally from the partially or completely processed digital baseband signal (54).

11. DARFA (50) according to claim 10, **characterized in that** the linear amplifier stage (33) comprises at least one operational amplifier (34).

12. DARFA (50) according to claim 10, **characterized in that** the switching amplifier stage (38) comprises a diode (42) and a MOSFET (41) connected in series, wherein the gate of the MOSFET (41) is connected to a MOSFET gate driver (39).

13. DARFA (50) according to claim 10, **characterized in that** modulator unit's (21) linear amplifier stage (33) is connected to the DSP unit (51) via an interface alignment stage (31), which converts the partially or completely processed digital baseband signal (54) into the analogue input signal (29) on baseband level.

14. DARFA (50) according to claim 10, **characterized in that** the DARFA (50) comprises a feedback loop comprising an analogue-to-digital converter (61), reading out the modulator output (28) or the output (25) of the RF power amplifier (22), and feedbacking to the DSP unit (51).

15. Use of a DARFA (50) according to claim 10 in a mobile telecommunication system or a user terminal or a satellite system.

## Patentansprüche

1. Verfahren zum Bedienen eines Funkfrequenzverstärkers mit Digitaleingang und Analogausgang, nachfolgend als DARFA (50) bezeichnet,
wobei ein digitales Eingangssignal (53) in einer digitalen Signalverarbeitungseinheit, nachfolgend als DSP-Einheit (51) bezeichnet, welche ein verarbeitetes digitales Basisbandsignal (54) aus dem digitalen Eingangssignal (53) erzeugt, verarbeitet wird, wobei ein analoges RF-Eingangssignal (24) mit einer nicht konstanten Hüllkurve aus dem verarbeiteten digitalen Basisbandsignal (54) erzeugt wird, wobei das analoge RF-Eingangssignal (24) in einen RF-Leistungsverstärker (22) eingespeist wird, welcher ein verstärktes analoges RF-Ausgangssignal (26) aus dem analogen RF-Eingangssignal (24) erzeugt,
wobei der RF-Leistungsverstärker (22) eine Versorgungsspannung (27a) von einer Modulatoreinheit (21) empfängt,
wobei die Modulatoreinheit (21) eine lineare Verstärkerstufe (33) und eine Schaltverstärkerstufe (38), deren Ausgänge (36, 37) zu einem gemeinsamen Modulatorausgang (28) kombiniert sind, welcher die Versorgungsspannung (27a) und den Versorgungsstrom bereitstellt, umfasst,
und wobei der Eingang (30) der linearen Verstärkerstufe (33) mit einem analogen Eingangssignal (29) gespeist wird, welches der Hüllkurve des verarbeiteten digitalen Basisbandsignals (54) entspricht,
**dadurch gekennzeichnet, dass**
die Schaltverstärkerstufe (38) mittels eines innerhalb der DSP-Einheit (51) erzeugten pulsweitenmodulierten Signals (44) gesteuert wird, wobei das pulsweitenmodulierte Signal (44) digital von dem teilweise oder vollständig verarbeiteten digitalen Basisbandsignal (54) abgeleitet wird.

2. Verfahren nach Anspruch 1, **dadurch gekennzeichnet, dass** das analoge Eingangssignal (29) für die lineare Verstärkerstufe (33) innerhalb der DSP-Einheit (51) erzeugt wird, wobei das besagte analoge Eingangssignal (29) digital von dem teilweise oder vollständig verarbeiteten digitalen Basisbandsignal (54) abgeleitet wird.

3. Verfahren nach Anspruch 1, **dadurch gekennzeichnet, dass** der DARFA (50) für die Erzeugung des analogen RF-Eingangssignals (24) einen analogen Mischer (57) umfasst, welcher ein RF-Trägersignal (58) mit dem verarbeiteten digitalen Basisbandsignal (54) mischt.

4. Verfahren nach Anspruch 1, **dadurch gekennzeichnet, dass** die DSP-Einheit (51) für die Erzeugung des analogen RF-Eingangssignals (24) eine digitale Mischstufe umfasst, welche das teilweise oder vollständig verarbeitete Basisbandsignal (54) mit einem RF-Trägersignal mischt.

5. Verfahren nach Anspruch 1, **dadurch gekennzeichnet, dass** die DSP-Einheit (51) für die Erzeugung des analogen RF-Eingangssignals (24) eine digitale Mischstufe umfasst, welche das teilweise oder vollständig verarbeitete digitale Basisbandsignal (54) mit einem IF-Signal mischt, und dass der DARFA (50) einen analogen Mischer umfasst, welcher ein RF-Trägersignal mit dem verarbeiteten IFgemischten digitalen Basisbandsignal mischt.

6. Verfahren nach Anspruch 1, **dadurch gekennzeichnet, dass** das verarbeitete digitale Basisbandsignal (54) eine Bandbreite zwischen 1 MHz und 100 MHz, insbesondere von etwa 30 MHz, aufweist, und dass das analoge RF-Eingangssignal (24) eine Trägerfrequenz zwischen 400 und 6000 MHz, insbesondere von etwa 1800 MHz oder 2100 MHz oder 2600 MHz, aufweist.

7. Verfahren nach Anspruch 1, **dadurch gekennzeichnet, dass** das analoge Eingangssignal (29) der Modulatoreinheit (21) digital von dem teilweise oder vollständig verarbeiteten Basisbandsignal (54) einschließlich eines digitalen Zeitabgleichs innerhalb der DSP-Einheit (51) abgeleitet, anschließend in ein analoges Basisbandsignal umgewandelt und über ein Schnittstellennetzwerk in den Eingang (30) der linearen Verstärkerstufe (33) eingespeist wird.

8. Verfahren nach Anspruch 1, **dadurch gekennzeichnet, dass** die Versorgungsspannung (27a) oder der Versorgungsstrom am Modulatorausgang (28) ausgelesen und als eine Rückkopplungsmessung für die Erzeugung des pulsweitenmodulierten Signals (44) in der DSP-Einheit (51), welches für die Steuerung der Schaltverstärkerstufe (38) der Modulatoreinheit (21) verwendet wird, benutzt wird.

9. Verfahren nach Anspruch 1, **dadurch gekennzeichnet, dass** das innerhalb der DSP-Einheit (51) pulsweitenmodulierte Signal (44) geeignet ist, die Hysterese und/oder Verzögerung in Teilen des DARFA (50) zu kompensieren.

10. Funkfrequenzverstärker mit Digitaleingang und Analogausgang, nachfolgend als DARFA (50) bezeichnet, wobei eine Versorgungsspannungs-Modulatoreinheit (21) des DARFA (50) vom Typ schaltunterstützter linearer Verstärker, nachfolgend als SMALA bezeichnet, ist, umfassend:
- Eine DSP-Einheit (51) zum Verarbeiten eines digitalen Eingangssignals (53) in ein verarbeitetes digitales Basisbandsignal (54),
- Mittel zum Erzeugen eines analogen RF-Eingangssignals (24) mit einer nicht konstanten Hüllkurve aus dem verarbeiteten digitalen Basisbandsignal (54),
- einen RF-Leistungsverstärker (22), dessen Eingang (23) an die besagten Mittel zum Erzeugen des analogen RF-Eingangssignals (24) angeschlossen ist,
- die Modulatoreinheit (21) mit einem Modulatorausgang (28), welcher an einen Versorgungsspannungseingang (27) des RF-Leistungsverstärkers (22) angeschlossen ist, wobei die Modulatoreinheit (21) eine lineare Verstärkerstufe (33) und eine Schaltverstärkerstufe (38), deren Ausgänge (36, 37) beide an den Modulatorausgang (28) angeschlossen sind, umfasst,
**dadurch gekennzeichnet, dass**
ein Steuereingang (40) der Schaltverstärkerstufe (38) an einen Steuerausgang (60) der DSP-Einheit (51), welcher ein digital von dem teilweise oder vollständig verarbeiteten digitalen Basisbandsignal (54) abgeleitetes pulsweitenmoduliertes Signal (44) bereitstellt, angeschlossen ist.

11. DARFA (50) nach Anspruch 10, **dadurch gekennzeichnet, dass** die lineare Verstärkerstufe (33) mindestens einen operativen Verstärker (34) umfasst.

12. DARFA (50) nach Anspruch 10, **dadurch gekennzeichnet, dass** die Schaltverstärkerstufe (38) eine Diode (42) und einen MOSFET (41), welche in Reihe geschaltet sind, umfasst, wobei das Gate des MOSFET (41) an einen MOSFET-Gate-Treiber (39) angeschlossen ist.

13. DARFA (50) nach Anspruch 10, **dadurch gekennzeichnet, dass** die lineare Verstärkerstufe (33) der Modulatoreinheit (21) über eine Schnittstellenabgleichstufe (31) an die DSP-Einheit (51), welche das teilweise oder vollständig verarbeitete digitale Basisbandsignal (54) in das analoge Eingangssignal (29) auf der Basisbandebene umwandelt, angeschlossen ist.

14. DARFA (50) nach Anspruch 10, **dadurch gekennzeichnet, dass** der DARFA (50) eine Rückkopplungsschleife mit einem Analog-/Digital-Wandler (61) umfasst, welcher den Modulatorausgang (28) oder den Ausgang (25) des RF-Leistungsverstärkers (22) ausliest und an die DSP-Einheit (51) rückkoppelt.

15. Verwendung eines DARFA (50) nach Anspruch 10 in einem mobilen Telekommunikationssystem oder einem Benutzerendgerät oder einem Satellitensystem.

## Revendications

1. Procédé de fonctionnement d'un amplificateur de radiofréquence entrée numérique/sortie analogique, ci-après appelé DARFA (50),
dans lequel un signal d'entrée numérique (53) est traité dans une unité de traitement de signal numérique, ci-après appelée unité DSP (51), générant un signal numérique en bande de base traité (54) à partir du signal numérique d'entrée (53), dans lequel un signal analogique RF d'entrée (24) avec une enveloppe non-constante est généré à partir du signal numérique en bande de base traité (54), dans lequel le signal analogique RF d'entrée (24) est envoyé dans un amplificateur de puissance RF (22) qui génère un signal analogique RF de sortie amplifié (26) à partir du signal analogique RF d'entrée (24),
dans lequel l'amplificateur de puissance RF (22) reçoit une tension d'alimentation (27a) provenant d'une unité de modulation (21),
dans lequel l'unité de modulation (21) comprend un étage d'amplificateur linéaire (33) et un étage d'amplificateur de commutation (38), dont les sorties (36, 37) sont combinées en une sortie commune de modulateur (28) fournissant la tension d'alimentation (27a) et le courant d'alimentation,
et dans lequel l'entrée (30) de l'étage d'amplificateur linéaire (33) est délivrée avec un signal analogique d'entrée (29) correspondant à l'enveloppe du signal numérique en bande de base traité (54),
**caractérisé en ce que**
l'étage d'amplificateur de commutation (38) est commandé au moyen d'un signal à modulation de largeur d'impulsion (44) généré à l'intérieur de l'unité DSP (51), dans lequel le signal à modulation de largeur d'impulsion (44) est dérivé numériquement du signal numérique en bande de base partiellement ou complètement traité (54).

2. Procédé selon la revendication 1, **caractérisé en ce que** le signal analogique d'entrée (29) pour l'étage d'amplificateur linéaire (33) est généré à l'intérieur de l'unité DSP (51), dans lequel ledit signal analogique d'entrée (29) est dérivé numériquement du signal en bande de base partiellement ou complètement traité (54).

3. Procédé selon la revendication 1, **caractérisé en ce que** pour générer le signal analogique RF d'entrée (24), le DARFA (50) comprend un mélangeur analogique (57), mélangeant un signal porteur RF (58) avec le signal numérique en bande de base traité (54).

4. Procédé selon la revendication 1, **caractérisé en ce que** pour générer le signal analogique RF d'entrée (24), l'unité DSP (51) comprend un étage mélangeur numérique qui mélange le signal en bande de base partiellement ou complètement traité (54) avec un signal porteur RF.

5. Procédé selon la revendication 1, **caractérisé en ce que** pour générer le signal analogique RF d'entrée (24), l'unité DSP (51) comprend un étage mélangeur numérique qui mélange le signal numérique en bande de base partiellement ou complètement traité (54) avec un signal FI, et le DARFA (50) comprend un mélangeur analogique, mélangeant un signal porteur RF avec le signal numérique en bande de base traité mélangé avec la FI.

6. Procédé selon la revendication 1, **caractérisé en ce que** le signal numérique en bande de base traité (54) présente une bande passante comprise entre 1 MHz et 100 MHz, en particulier environ 30 MHz, et **en ce que** le signal analogique RF d'entrée (24) présente une fréquence porteuse comprise entre 400 et 6000 MHz, en particulier environ 1800 MHz ou 2100 MHz ou 2600 MHz.

7. Procédé selon la revendication 1, **caractérisé en ce que** le signal analogique d'entrée (29) de l'unité de modulation (21) est dérivé numériquement du signal numérique en bande de base partiellement ou complètement traité (54) comprenant un alignement temporel numérique à l'intérieur de l'unité DSP (51), converti par la suite en un signal analogique en bande de base et envoyé dans l'entrée (30) de l'étage d'amplificateur linéaire (33) par l'intermédiaire d'un réseau d'interface.

8. Procédé selon la revendication 1, **caractérisé en ce que** la tension d'alimentation (27a) ou le courant d'alimentation au niveau de la sortie du modulateur (28) est lu et utilisé comme mesure de rétroaction pour la génération du signal à modulation de largeur d'impulsion (44) dans l'unité DSP (51) utilisé pour commander l'étage d'amplificateur de commutation (38) de l'unité de modulation (21).

9. Procédé selon la revendication 1, **caractérisé en ce que** le signal à modulation de largeur d'impulsion (44) généré à l'intérieur de l'unité DSP (51) est adapté pour compenser l'hystérésis et/ou le retard dans des parties du DARFA (50).

10. Amplificateur de radiofréquence entrée numérique/sortie analogique, ci-après appelé DARFA (50), dans lequel une unité de modulation de tension d'alimentation (21) du DARFA (50) est du type amplificateur linéaire assisté par mode de commutation, ci-après appelé SMALA, comprenant
- une unité DSP (51) pour générer un signal numérique en bande de base traité (54) à partir d'un signal numérique d'entrée (53).
- des moyens pour générer un signal analogique RF d'entrée (24) avec une enveloppe non constante à partir du signal numérique en bande de base traité (54),
- un amplificateur de puissance RF (22), dont l'entrée (23) est connectée auxdits moyens pour générer le signal analogique RF d'entrée (24),
- l'unité de modulation (21), avec une sortie du modulateur (28) qui est connectée à une entrée de tension d'alimentation (27) de l'amplificateur de puissance RF (22), dans lequel l'unité de modulation (21) comprend un étage d'amplificateur linéaire (33) et un étage d'amplificateur de commutation (38), dont les sorties (36, 37) sont toutes les deux connectées à la sortie du modulateur (28),
**caractérisé en ce que**
une entrée de commande (40) de l'étage d'amplificateur de commutation (38) est connectée à une sortie de commande (60) de l'unité DSP (51) fournissant un signal à modulation de largeur d'impulsion (44) dérivé numériquement du signal numérique en bande de base partiellement ou complètement traité (54).

11. DARFA (50) selon la revendication 10, **caractérisé en ce que** l'étage d'amplificateur linéaire (33) comprend au moins un amplificateur opérationnel (34).

12. DARFA (50) selon la revendication 10, **caractérisé en ce que** l'étage d'amplificateur de commutation (38) comprend une diode (42) et un MOSFET (41) connectés en série, dans lequel la grille du MOSFET (41) est connectée à un pilote de grille de MOSFET (39).

13. DARFA (50) selon la revendication 10, **caractérisé en ce que** l'étage d'amplificateur linéaire (33) de l'unité de modulation (21) est connecté à l'unité DSP (51) par l'intermédiaire d'un étage d'alignement d'interface (31), qui convertit le signal numérique en bande de base partiellement ou complètement traité (54) en un signal analogique d'entrée (29) au niveau de la bande de base.

14. DARFA (50) selon la revendication 10, **caractérisé en ce que** le DARFA (50) comprend une boucle de rétroaction comprenant un convertisseur analogique/numérique (61), lisant la sortie du modulateur (28) ou la sortie (25) de l'amplificateur de puissance RF (22), et la retournant à l'unité DSP (51).

15. Utilisation d'un DARFA (50) selon la revendication 10 dans un système de télécommunications mobiles ou un terminal utilisateur ou un système satellite.
